# EUROPEAN PATENT APPLICATION

(11) **EP 2 899 755 A1**
(43) Date of publication of application: **29.07.2015**
(21) Application number: 15151288.6
(22) Date of filing: 15.01.2015
(51) Int. Cl.: H01L 23/528, H01L 23/31

(54) **Semiconductor package**

(30) Priority: 22.01.2014 US 201461930041 P; 03.07.2014 US 201414323107
(71) Applicant: MediaTek, Inc, Hsin-Chu 300 (TW)
(72) Inventor: Lin, Tzu-Hung, 302 Zhubei City, Hsinchu County (TW)
(74) Representative: Goddar, Heinz J.

(57) **Abstract**

The invention provides a semiconductor package. The semiconductor package includes a first semiconductor die having pads thereon. A first via and a second via are respectively disposed on the first semiconductor die. The first via connects to at least two of the pads of the first semiconductor die.

## Description

### CROSS REFERENCE TO RELATED APPLICATIONS

This application claims the benefit of U.S. Provisional Application No. 61/930,041 filed January 22, 2014, the entirety of which is incorporated by reference herein.

### BACKGROUND OF THE INVENTION

### Field of the Invention

The present invention relates to a semiconductor package, and in particular relates to a via design for a semiconductor package.

### Description of the Related Art

For a semiconductor chip package design, an increased amount of input/output (I/O) connections for multi-functional chips is required. The impact of this will be pressure on printed circuit board (PCB) fabricators to minimize linewidth and space or to develop direct chip attach (DCA) semiconductors. However, the increased amount of input/output connections of a multi-functional chip package may induce thermal electrical problems, for example, problems with heat dissipation, cross talk, signal propagation delay, electromagnetic interference in RF circuits, etc. The thermal electrical problems may affect the reliability and quality of products.

Thus, a novel semiconductor package is desirable.

### BRIEF SUMMARY OF THE INVENTION

A semiconductor package is provided. An exemplary embodiment of a semiconductor package includes a first semiconductor die having pads thereon. A first via and a second via are respectively disposed on the first semiconductor die. The first via connects to at least two of the pads of the first semiconductor die.

Another exemplary embodiment of a semiconductor package includes a first semiconductor die having a first pad and a second pad thereon. The first and second pads are both power pads or ground pads. A first via is disposed on the first semiconductor die, wherein the first via connects to both the first and second pads of the first semiconductor die.

Yet another exemplary embodiment of a semiconductor package includes a first semiconductor die having pads thereon. A first via is disposed on the first semiconductor die. The first conductive bump connects to the pads of the first semiconductor die. The first via is mesh-shaped or ring-shaped from a plan view.

A detailed description is given in the following embodiments with reference to the accompanying drawings.

### BRIEF DESCRIPTION OF THE DRAWINGS

The present invention can be more fully understood by reading the subsequent detailed description and examples with references made to the accompanying drawings, wherein:
FIG. 1 is a cross-sectional view of a semiconductor package in accordance with some embodiments of the disclosure.
FIG. 2 is a bottom view of a first semiconductor die of a semiconductor package, showing the layout of vias of the first semiconductor die of the semiconductor package, in accordance with some embodiments of the disclosure.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is determined by reference to the appended claims.

The present invention will be described with respect to particular embodiments and with reference to certain drawings, but the invention is not limited thereto and is only limited by the claims. The drawings described are only schematic and are non-limiting. In the drawings, the size of some of the elements may be exaggerated and not drawn to scale for illustrative purposes. The dimensions and the relative dimensions do not correspond to actual dimensions in the practice of the invention.

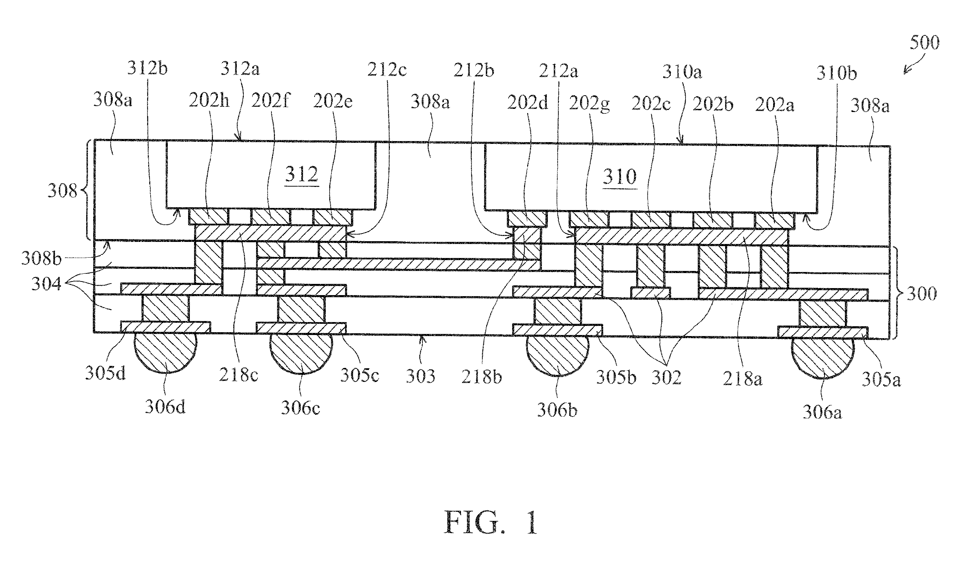

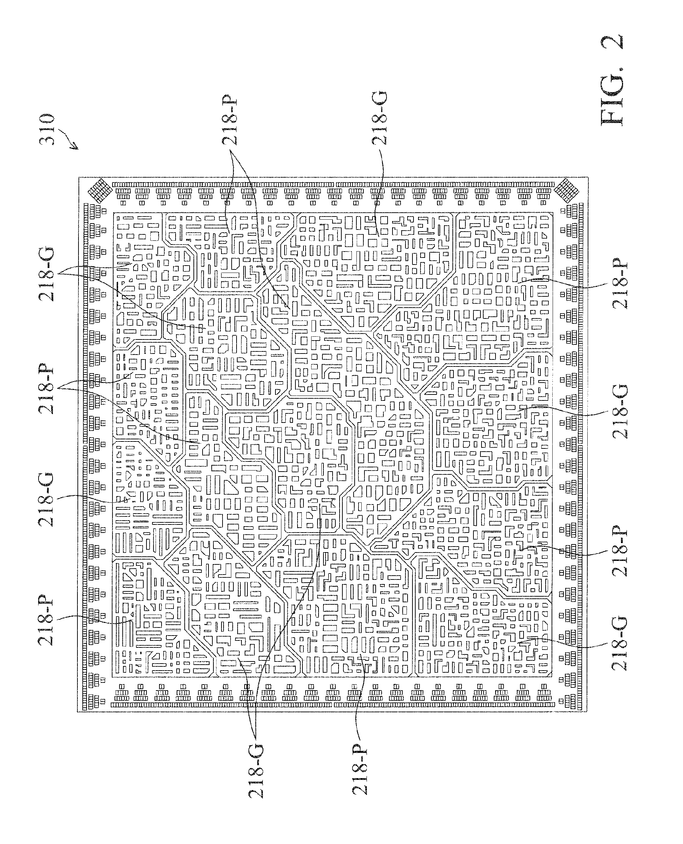

FIG. 1 is a cross-sectional view of a semiconductor package 500 in accordance with some embodiments of the disclosure. In some embodiments, the semiconductor package 500 can be a wafer level package assembly using vias connecting a semiconductor device to a redistribution layer (RDL) structure. As illustrated in FIG. 1, the semiconductor package 500 includes a redistribution layer (RDL) structure 300, a first semiconductor die 310, a second semiconductor die 312 and vias 218a-218c in accordance with some embodiments of the disclosure. However, it should be noted that the first semiconductor die 310 and the second semiconductor die 312 shown in FIG. 1 are only an example and are not a limitation on the number of semiconductor dies in the semiconductor package of the present invention. In some other embodiments, the semiconductor package 500 includes a single semiconductor die or more than two semiconductor dies. Also, for the clear illustration of the vias used for power or ground pads of the semiconductor dies, the vias used as electrical connections for a signal pad of a signal semiconductor die are not shown in the figures (FIGS. 1 and 2).

As shown in FIG. 1, the first semiconductor die 310 and the second semiconductor die 312 separated from each other are attached to a carrier (not shown) through an adhesive layer (not shown). A backside surface 310a of the first semiconductor die 310 and a backside surface 312a of the second semiconductor die 312 are in contact with the carrier. A top surface 310b of the first semiconductor die 310 and a top surface 312b of the second semiconductor die 312 may face away from the carrier 112. The carrier may be configured to provide structural rigidity or a base for deposition of subsequent non-rigid layers.

As shown in FIG. 1, the second semiconductor die 312 is disposed beside the first semiconductor die 310. In some other embodiments, the second semiconductor die 312 is disposed on the first semiconductor die 310. Circuitries of the first semiconductor die 310 and the second semiconductor die 312 are disposed close to the top surfaces 310b and 312b, respectively. In some embodiments, pads 202a-202d and 202g are disposed on the top surface 310b of the first semiconductor die 310 to be electrically connected to the circuitry of the first semiconductor die 310. Pads 202e, 202f and 202h are disposed on the top surface 312b of the second semiconductor die 312 to be electrically connected to the circuitry of the second semiconductor die 312. In some embodiments, the pads 202a-202d and 202g belong to the uppermost metal layer of the interconnection structure (not shown) of the first semiconductor die 310. Similarly, the pads 202e, 202f and 202h belong to the uppermost metal layer of the interconnection structure (not shown) of the second semiconductor die 312. In some embodiments, the pads 202a-202d and 202g are arranged in the central area of the first semiconductor die 310 to be used to transmit ground or power signals of the first semiconductor die 310. The pads 202e, 202f and 202h are arranged in the central area of the second semiconductor die 312 to be used to transmit ground or power signals of the second semiconductor die 312. Therefore, the pads 202a-202h may serve as ground or power pads.

As shown in FIG. 1, a molding compound 308a may be applied to the carrier, and may surround the first semiconductor die 310 and the second semiconductor die 312, and filling any gaps around the first semiconductor die 310 and the second semiconductor die 312 to form a molded substrate 308. The molded substrate 308 also cover the top surfaces 310b and 312b of the first semiconductor die 310 and the second semiconductor die 312. In some embodiments, the molded substrate 308 may be formed of a nonconductive material, such as an epoxy, a resin, a moldable polymer, or the like. The molding compound 308a may be applied while substantially liquid, and then may be cured through a chemical reaction, such as in an epoxy or resin. In some other embodiments, the molding compound 308a may be an ultraviolet (UV) or thermally cured polymer applied as a gel or malleable solid capable of being disposed around the first semiconductor die 310 and the second semiconductor die 312. In an embodiment employing a UV or thermally cured molding compound 308a, the molded substrate 308 may be formed in place using a mold, for example, bordering the perimeter of the molded area, such as a wafer or package.

As shown in FIG. 1, openings 212a-212c are formed passing through a portion of the molded substrate 308 from a surface of the molded substrate 308, which is close to the top surfaces 310b and 312b of the first semiconductor die 310 and the second semiconductor die 312, by a photolithography process. In some embodiments, the openings 212a-212c are respectively formed corresponding to the pads 202a-202h. More specifically, the opening 212a is formed corresponding to the four pads 202a-202c and 202g. The opening 212b is formed corresponding to the pad 202d. The opening 212c is formed corresponding to the three pads 202e-202f and 202h. In some embodiments, an area of the opening may be designed to be larger than that of any the pads of the first semiconductor die 310 and the second semiconductor die 312. For example, an area of the opening 212a may be designed to be larger than that of the pad 202a, 202b or 202c of the first semiconductor die 310. An area of the opening 212c may be designed to be larger than that of the pad 202e, 202f or 202h of second semiconductor die 312.

As shown in FIG. 1, vias 218a-218c are formed filling the openings 212a-212c, respectively. Therefore, the vias 218a-218c may be formed surrounded by the molded substrate 308. In some embodiments, the vias 218a-218c may be formed of copper, aluminum, gold, palladium, silver, alloys of the same, or another conductive material.

In some embodiments, the via 218a is designed to be electrically coupled to four pads, such as the pads 202a-202c and 202g, disposed on the first semiconductor die 310. The via 218a partially overlaps the pads 202a-202c and 202g. That is to say, at least a portion of the via 218a is exposed to spaces between the at least two of the pads 202a-202c and 202g. The via 218c is designed to connect three pads, such as the pads 202e-202f and 202h, disposed on the second semiconductor die 312. The via 218c partially overlaps the pads 202e-202f and 202h. That is to say, at least a portion of the via 218c is exposed to spaces between the at least two of the pads 202e-202f and 202h. The via 218b is designed to be in contact with the single pad 202d disposed on the first semiconductor die 310 as shown in FIG.1. The via 218b fully overlaps the single pad 202d. It is noted that the via 218b is electrically connected to the via 218c through the redistribution layer (RDL) structure 300. However, it should be noted that the number of pads designed to be connected to the same via shown in FIG. 1 is only an example and is not a limitation to the present invention. In some embodiments, an area of the via may be designed to be larger than that of any the pads of the first semiconductor die 310 and the second semiconductor die 312. For example, an area of the via 218a may be designed to be larger than that of the pad 202a, 202b or 202c of the first semiconductor die 310. An area of the via 218c may be designed to be larger than that of the pad 202e, 202f or 202h of second semiconductor die 312.

It should be noted that the pads designated to be connected to the same via have the same function. For example, the pads 202a-202c and 202g of the first semiconductor die 310 designated to be connected to the single via 218a may serve as ground pads 202a-202c and 202g. Alternatively, the pads 202a-202c and 202g of the first semiconductor die 310 designated to be connected to the via 218a may serve as power pads 202a-202c and 202g, which are used to provide the same voltage. Similarly, the pads 202e-202f and 202h of the second semiconductor die 312 designated to be connected to the via 218c may serve as ground pads 202e-202f and 202h or power pads 202e-202f and 202h. However, it should be noted that the connections between the vias and the conductive traces shown in FIG. 1 are only an example and re not a limitation to the present invention.

As shown in FIG. 1, it should be noted that some of the vias of the semiconductor package 500 are designed to have a routing function. Therefore, some of the vias on the first semiconductor die 310 or the second semiconductor die 312 can be designed to connect several pads having the same function. For example, the via can be designed to connect adjacent ground pads on the first semiconductor die 310 or the second semiconductor die 312. Alternatively, the via can be designed to connect adjacent power pads, which are used to provide the same voltage, on the first semiconductor die 310 or the second semiconductor die 312. Therefore, the vias can be designed as redistribution layer patterns or delivery networks to connect adjacent ground/power pads arranged in a certain region of the first semiconductor die 310 or the second semiconductor die 312. In some embodiments, the redistribution layer patterns composed of the vias are arranged to have a mesh-shape or ring-shape in a plan view.

As shown in FIG. 1, the redistribution layer (RDL) structure 300 is disposed on a side 308b of the molding compound 308, which is close to the pads 202a-202h. The RDL structure 300 may be in contact with the molded substrate 308 and the pads 202a-202h of the first semiconductor die 310 and the second semiconductor die 312. In some embodiments, the RDL structure 300 may have one or more conductive traces 302 disposed in intermetal dielectric (IMD) layers 304. The conductive traces 302 are respectively electrical connected to RDL contact pads 305a-305d, However, it should be noted that the number of the conductive traces 302, the IMD layers 304 and the RDL contact pads 305a-305d designed to be connected to the same via shown in FIG. 1 is only an example and is not a limitation to the present invention. The semiconductor package 500 uses the vias 218a-218c respectively connecting the power and ground pads (e.g. the pads 202a-202h) of the first semiconductor die 310 and the second semiconductor die 312 to the conductive traces 302 of the redistribution layer (RDL) structure 300, in accordance with some embodiments of the disclosure (the via used for the signal pad of the semiconductor dies are not shown in FIG. 1). The conductive traces 302 may be designed to be fan out from one or more of the vias 218a-218c and provide an electrical connection between the pads 202a-202h of the first semiconductor die 310 and the second semiconductor die 312 and the RDL contact pads 305a-305d. Therefore, the RDL contact pads 305a-305d may have a larger bond pitch than the pads 202a-202h of the first semiconductor die 310 and the second semiconductor die 312, and which may be suitable for a ball grid array or other package mounting system. In some embodiments, the RDL structure 300 may also have the conductive traces 302 that connect one or more vias 218a-218c to the RDL contact pads 305a-305d. For example, one of the conductive traces 302 may electrically connect the via 218b of the first semiconductor die 310 and the via 218c of the second semiconductor die 312 to the two RDL contact pads 305c and 305d. For example, one of the conductive traces 302 may electrically connect to the via 218a to the RDL contact pads 305a and 305b.

As shown in FIG. 1, package mounts 306a-306d may be respectively disposed on the RDL contact pads 305a-305d, and the first semiconductor die 310 and the second semiconductor die 312 may then be tested. The package mounts 306a-306d may be disposed on a surface 303 of the RDL structure 300 away from the first semiconductor die 310 and the second semiconductor die 312. The package mounts 306a-306d are coupled to the conductive traces 302, respectively. In some embodiments, the package mounts 306a-306d may be, for example, solder balls comprising a ball grid array. In some othe embodiments, the package mounts 306a-306d may be a land grid array (LGA), a pin array, or another suitable package attachment system.

IFIG. 2 is a bottom view of the first semiconductor die 310 of the semiconductor package 500. FIG. 2 also shows a layout of vias 218-P and 218-G of the first semiconductor die 310 of the semiconductor package 500, in accordance with some embodiments of the disclosure. It should be noted that for the clear illustration of the vias 218-P and 218-G used for power or ground pads (for example, pads 210a-210d) of first semiconductor die 310, the vias used for signal pad of the first semiconductor die 310 (such as the via 218b as shown in FIG. 1) are not shown in FIG. 2. It should be noted that a layout of the vias 218c of the second semiconductor die 312 may be also similar to the layout of the vias 218-P and 218-G of the first semiconductor die 310.

In some embodiments as shown in FIG. 2, the vias 218-P are designed to serve as redistribution routings for the power pads of the first semiconductor die 310. In some embodiments as shown in FIG. 2, the vias 218-G are designed to serve as redistribution routings for the ground pads of the first semiconductor die 310. In some embodiments, the vias 218-P and 218-G of the first semiconductor die 310 are designed to be disposed close to a central area of the first semiconductor die 310 to connect the corresponding power or ground pads of the first semiconductor die 310 as shown in FIG. 2. In some other embodiments, the vias 218-P and 218-G of the first semiconductor die 310 can be designed to be arranged in the peripheral area (e.g. the area surrounding the vias 218-P and 218-G as shown in FIG. 2) of the first semiconductor die 310, accordingly the arrangements of the power or ground pads.

In some embodiments as shown in FIG. 2, the vias 218-P and 218-G on the first semiconductor die 310 are designed to connect several pads having the same function. For example, the vias 218-G can be designed to connect adjacent ground pads of the first semiconductor die 310. Alternatively, the vias 218-P can be designed to connect adjacent power pads, which are used to provide the same voltage, of the first semiconductor die 310. Therefore, the vias 218-P/218-G can be designed to serve as power/ground delivery networks to connect adjacent ground/power pads arranged in a certain region of the first semiconductor die 310. In some embodiments, the vias 218-P and 218-G arranged as the power/ground delivery networks of the first semiconductor die 310 have a mesh-shape or ring-shape as shown in FIG. 2. It should be noted that the shape of the vias 218c of the second semiconductor die 312 in a plan view may be similar to that of the vias 218-P and 218-G of the first semiconductor die 310 as shown in FIG. 2.

In some embodiments as shown in FIG. 2, the vias 218-P can be arranged as the power delivery networks to further enlarge the area of the routings for the power pads of the first semiconductor die 310. When the signals are transmitted from the first semiconductor die 310 to the redistribution layer (RDL) structure 300 or to the second semiconductor die 312 (FIG. 1), the vias 218-P can improve the signal integrity of the signals. It should be noted that when the vias 218c are designed to connect to the power pads of the second semiconductor die 312 as shown in FIG. 1, the vias 218c may also improve the signal integrity of the signals.

In some embodiments as shown in FIG. 2, the vias 218-G can be arranged as the ground delivery networks to further enlarge the area of the routings for the ground pads of the first semiconductor die 310. The enlarged ground delivery networks composed by the vias 218-G can improve the shielding ability of the vias 218-P. It should be noted that when the vias 218c are designed to connect to the ground pads of the second semiconductor die 312 as shown in FIG. 1, the vias 218c may also improve the shielding ability of other vias used for connecting the power pads.

Embodiments provide a semiconductor package. The semiconductor package can use the vias. Etch of the vias is desiged to be in connect with a plurality pads of power or ground pads of the semiconductor die to the redistribution layer (RDL) structure. In some embodiments, the vias can be designed to serve as redistribution layer patterns or delivery networks to connect adjacent ground/power pads arranged in a certain region of the semiconductor die. In some embodiments, the vias can be arranged as the redistribution networks of the semiconductor die and have a mesh-shape or ring-shape. In some embodiments, the vias arranged as the power redistribution layer patterns/delivery networks can improve the signal integrity of the signals, while the signals are transmitted from the semiconductor die to the redistribution layer (RDL) structure 300 or to another semiconductor die. In some embodiments, the vias arranged as the ground redistribution layer patterns/delivery networks can improve the shielding ability for other vias used for connecting the power pads.

While the invention has been described by way of example and in terms of the preferred embodiments, it is to be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A semiconductor package (500), comprising:
a first semiconductor die (310) having pads (202a, 202b, 202c, 202d, 202g) thereon; and
a first via (218a) and a second via (218b) respectively disposed on the first semiconductor die (310), wherein the first via (218a) connects to at least two of the pads (202a, 202b, 202c, 202g) of the first semiconductor die (310).

2. The semiconductor package as claimed in claim 1, wherein the second via (218b) connects to a single one of the pads (202d) of the first semiconductor die (310).

3. The semiconductor package as claimed in claim 1 or 2, wherein the first via (218-P, 218-G) is mesh-shaped or ring-shaped from a plan view.

4. The semiconductor device as claimed in any of claims 1 to 3, wherein an area of the first via is larger than that of the second via.

5. The semiconductor package as claimed in any of claims 1 to 4, wherein the at least two of the pads are power pads or ground pads.

6. The semiconductor device as claimed in any of claims 1 to 5, wherein an area of the first via is larger than that of any of the pads.

7. The semiconductor device as claimed in any of claims 1 to 6, further comprising:
a redistribution layer (RDL) structure (300) having a first conductive trace and a second conductive trace (302) thereon, wherein the first via and the second via are in contact with the first conductive trace and the second conductive trace, respectively.

8. The semiconductor device as claimed in claim 7, further comprising:
a molding substrate (308) surrounding first semiconductor die (310), being in contact with the redistribution layer (RDL) structure (300) and the first semiconductor die (310); and
a first package mount (306a, 306b) and a second package mount (306c) disposed on a surface (303) of the redistribution layer (RDL) structure away from the first semiconductor die wherein the first package mount and the second package mount are coupled to the first conductive trace and the second conductive trace, respectively.

9. The semiconductor package as claimed in any of claims 1 to 8, further comprising:
a second semiconductor die (312) disposed beside the first semiconductor die (310).

10. The semiconductor package as claimed in any of claims 1 to 8, further comprising:
a second semiconductor die (312) disposed on the first semiconductor die (310).

11. The semiconductor package as claimed in any of claims 1 to 10, wherein the first via (218a) connects a first number of the pads, and the second via (218b) connects a second number of the pads, and wherein the first number is different from the second number.

12. The semiconductor package as claimed in claim 11, wherein the first number is greater than the second number

13. The semiconductor package as claimed in any of claims 1 to 12, wherein the first via (218a) partially overlaps the at least two of the pads (202a, 202b, 202c, 202g).

14. The semiconductor package as claimed in claim 2, wherein the second via (218b) fully overlaps the single one of the pads (202d).

15. The semiconductor package as claimed in any of claims 1 to 14, wherein a portion of the first via (218a) is exposed to a space between the at least two of the pads (202a, 202b, 202c, 202g).
